# EUROPEAN PATENT SPECIFICATION

(11) **EP 3 465 782 B1**
(45) Date of publication and mention of the grant of the patent: **12.02.2020**
(21) Application number: 17725554.4
(22) Date of filing: 16.05.2017
(51) Int. Cl.: H01L 41/047, H01L 41/08, H01L 41/318, H01L 41/29

(54) **TRANSPARENT PIEZOELECTRIC DEVICE AND METHOD FOR MANUFACTURING THE SAME**
TRANSPARENTE PIEZOELEKTRISCHE VORRICHTUNG UND VERFAHREN ZUR HERSTELLUNG DAVON
DISPOSITIF PIÉZOÉLECTRIQUE TRANSPARENT ET SON PROCÉDÉ DE FABRICATION

(30) Priority: 24.05.2016 LU 93084
(43) Date of publication of application: 10.04.2019
(73) Proprietor: Luxembourg Institute of Science and Technology (LIST), 4362 Esch-sur-Alzette (LU)
(72) Inventor: SETTE, Daniele, 38000 Grenoble (FR); DEFAY, Emmanuel, 1933 Luxembourg (LU)
(74) Representative: Lecomte & Partners
(86) International application number: PCT/EP2017/061757
(87) International publication number: WO 2017/202652

(56) References cited:
- WO-A1-2016/071688
- JP-A- 2002 342 016
- TW-A- 201 108 477
- US-A1- 2012 012 840
- US-A1- 2013 169 599

## Description

### Technical field

The invention is directed to a transparent piezoelectric device. The invention is also directed to a method for producing a transparent piezoelectric device.

### Background art

Transparent piezoelectric devices usually have a Metal-Insulator-Metal (MIM) structure. They comprise a transparent substrate and a transparent piezoelectric layer, said piezoelectric layer being comprised between two transparent layers of electrodes, as it is described in the patent document published WO/2013164540. However, these devices are massive and present high probabilities of short-circuit.

Prior art patent document published CN105185898 discloses a transparent and flexible piezoelectric device. The device comprises a mica layer on which a layer of electrodes is disposed. The layer of electrodes is transparent and consists of interdigitated electrodes. The layer of electrodes is then covered by piezoelectric materials consisting of nanowires of Lead Zirconate Titanate (PZT). The device also comprises two protective layers which are bonded to the upper and lower sides of the electrode layer. However, the device is flexible and miniature. The interdigitated electrodes are formed on a mica substrate which has then to be thinned. The piezoelectric layer consists of nanowires which have to be bounded or mixed with the interdigitated electrodes. Moreover, the contact of the piezoelectric material is heterogeneous because the PZT nanowires are deposited on the electrodes and on the mica substrate. The method of depositing the piezoelectric layer does not allow to have a homogeneous piezoelectric layer. The device presents insufficient contact between the PZT nanowires and the layer of electrodes.

Further, each of the documents US 2013/169599 A, JP 2002-342016 A, and TW 201 108 477 A discloses a transparent piezoelectric device according to the preamble of claim 1.

### Summary of invention

### Technical Problem

The invention has for technical problem to provide a solution to at least one shortcoming of the prior art. More particularly, the invention has for technical problem to provide a transparent piezoelectric device on a transparent substrate. The invention has also for technical problem to provide a time and cost effective method of production.

### Technical solution

The invention is directed to a transparent piezoelectric device comprising a transparent substrate, a transparent piezoelectric layer, a layer of transparent, interdigitated electrodes; wherein the piezoelectric layer is disposed between the substrate and the layer of interdigitated electrodes, said device further comprises a transparent dielectric layer between the substrate and the piezoelectric layer, the dielectric layer having a thickness comprised between 1 and 30 nm.

According to a preferred embodiment, the transparent piezoelectric layer is a uniform deposited layer.

According to a preferred embodiment, the layer of interdigitated electrodes comprises two coplanar electrodes, each electrode having a plurality of fingers which are interdigitated.

According to a preferred embodiment, the piezoelectric layer covers at least 10% of the surface of the transparent substrate, preferably at least 50%, more preferably at least 70%.

According to a preferred embodiment, the layer of electrodes comprises a conductive transparent metal oxide.

According to a preferred embodiment, the substrate is a fused silica wafer.

According to a preferred embodiment, the substrate is a glass substrate.

According to a preferred embodiment, the piezoelectric layer has a thickness of less than 10 µm, preferably higher than 0.1µm and/or lower than 2 µm.

According to a preferred embodiment, the dielectric layer has a thickness lower than 20 nm.

The invention is also directed to a method for producing a transparent piezoelectric device, said method comprising the following steps of providing a transparent substrate; depositing a transparent piezoelectric layer on the transparent substrate; depositing a layer of transparent, interdigitated electrodes on the transparent substrate; wherein the step of depositing a transparent piezoelectric layer is performed before the step of depositing the layer of interdigitated electrodes, said method further comprises a step of depositing a transparent dielectric layer on the transparent substrate before the step of depositing a transparent piezoelectric layer on the transparent substrate, the dielectric layer having a thickness comprised between 1 and 30 nm.

According to a preferred embodiment, the step of depositing a transparent piezoelectric layer is performed by spin coating and a sol-gel method.

According to a preferred embodiment, the step of depositing a layer of interdigitated electrodes is performed by atomic layer deposition and lift-off lithography, and/or lithography and etching.

According to a preferred embodiment, the sol-gel method comprises the following sequential steps of drying; pyrolizing; and crystallizing.

According to a preferred embodiment, the spin coating and the steps of drying and pyrolizing are repeated 3 times.

### Advantages of the invention

The invention is particularly interesting in that the device presents a good contact between the piezoelectric layer and the layer of electrodes because of the conformal deposition of electrodes on the piezoelectric layer. The coplanar deposition of the electrodes on the piezoelectric layer allows avoiding short-circuits. The configuration of the device also provides a good optimization of the piezoelectric material. The method allows a conformal deposition of the piezoelectric layer on transparent and rigid substrates and the formation of piezoelectric device on large area. The method also provides a time and cost effective solution to produce a transparent piezoelectric device.

### Brief description of the drawings

Figure 1 shows a top view of the device according to the invention.
Figure 2 represents a cross-section of the device according to figure 1.
Figure 3 shows the evolution of the electric displacement (µC/cm²) of the device according to a bias voltage (V).
Figure 4 shows the evolution of the capacitance (pF) and the loss factor tan (δ) according to a bias voltage (V).
Figure 5 is a flowchart showing the major steps of the method according to the invention.

### Description of an embodiment

In the following description the term "transparent" is used to mean that a material or a device transmits at least 40%, preferably at least 70%, more preferably at least 90% of the incident visible light.

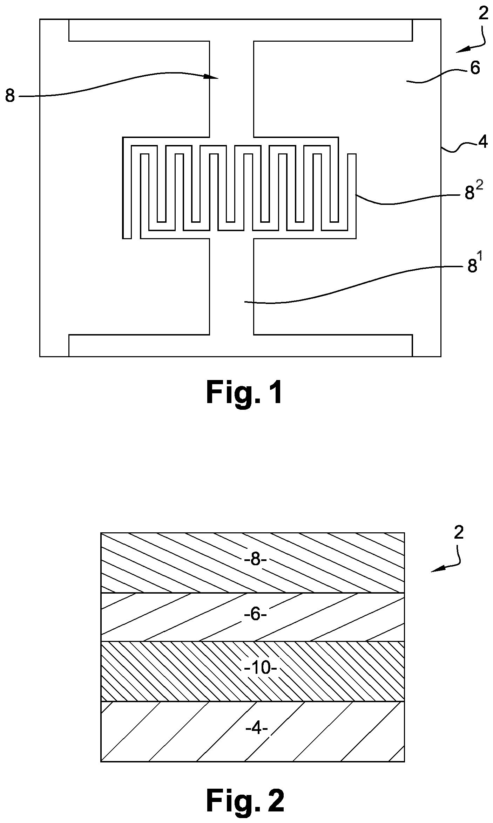

Figure 1 represents the piezoelectric device 2 according to the invention. The device 2 comprises a transparent substrate 4 (not visible in figure 1), a transparent piezoelectric layer 6 and a layer 8 of transparent, interdigitated electrodes. The piezoelectric layer 6 is disposed between the substrate 4 and the layer 8 of interdigitated electrodes. The transparent piezoelectric layer 6 is a uniform deposited layer of piezoelectric materials or a continuous film of piezoelectric materials. The piezoelectric layer does not contain nanowires, nanorods, nanospheres or the like. The piezoelectric layer preferably comprises PZT. (Pb,La)(Zr,Ti)O₃, Pb(Mg,Nb)TiO₃-PbTiO₃, BiFeO₃, (Ba,Ca)(Ti,Zr)O₃₊, AIN, Sc doped-AIN, ZnO, LiNbO₃ can also be used. The layer 8 of interdigitated electrodes can comprise two coplanar electrodes 8¹. The two electrodes 8¹ are opposite electrodes and each of the electrodes can comprise a plurality of fingers 8², preferably between 5 and 10, more preferably 7, which are alternated and spaced between them. The two electrodes 8¹ can have the form of two interdigitated combs. Each finger 8² has a width comprised between 1 and 50 µm, preferably 10 µm. The fingers 8² can be spaced from each other with a gap or an interdigital space comprised between 1 and 50µm. The fingers can have a length comprised between 10 and 10000 µm, preferably 50 µm. The form of the electrodes is not limiting and the electrodes can have other form. For example, they can be semi-circular. By the below method, it will be seen that the dimensions of the device including the dimensions and the numbers of the fingers of the electrodes can vary.

The layer 8 of interdigitated electrodes comprises a transparent metal oxide. Preferably, the layer 8 of interdigitated electrodes comprise Al-doped ZnO (AZO). Indium Tin Oxide (ITO), RuO₂ or IrO₂ can also be used.

The piezoelectric layer 6 covers at least 10% of the surface of the transparent substrate 4, preferably at least 50%, more preferably at least 70% of the surface of the substrate.

The device 2 transmits at least 40%, preferably at least 70%, more preferably 90% of the incident visible light. The device 2 can have wide applications. The device 2 can be used as a sensor, an actuator or in energy harvesting or in others applications. The device has a piezoelectric actuation mode d33, which corresponds to the longitudinal piezoelectric strain coefficient.

Figure 2 is a cross sectional view of the device according to figure 1. The device 2 comprises the transparent substrate 4 at the bottom. The substrate 4 can be a fused silica wafer. The transparent piezoelectric layer 6 is above the substrate 4 and is disposed between the substrate 4 and the transparent layer 8 of interdigitated electrodes. The transparent piezoelectric layer 6 has a thickness of less than 10 µm, preferably higher than 0.1 µm and/or lower than 2 µm. The layer 8 of transparent, interdigitated electrodes has a thickness comprised between 20 nm and 10 µm, preferably comprised between 100 nm and 1 µm.

The device 2 also comprises a transparent dielectric layer 10 between the substrate 4 and the transparent piezoelectric layer 6. The dielectric layer 10 has a thickness comprised between 5 and 30 nm, preferably higher than 5 and/or lower than 20 nm. The dielectric layer is preferably a layer of TiO₂. ZrO₂, Al₂O₃ or the like, HfO₂, AIN, PbTiO₃, PbZrO₃, BiFeO₃, PbO, Y₂O₃, CeO₂ can also be used to form the dielectric layer. The device 2 can also comprise a protective transparent layer above the layer of electrodes.

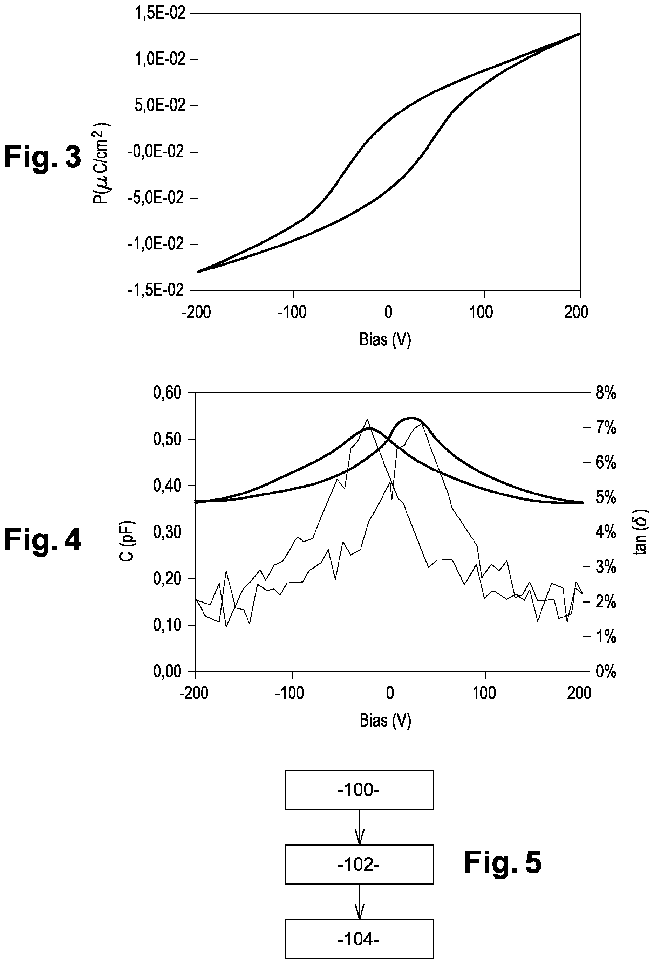

The piezoelectric device according to the invention has been tested in order to control its performance. More particularly, the device under tests comprises 2 electrodes with 7 fingers, each finger having a length of 50 µm, a width of 10 µm and a gap or interdigital space of 5 µm. The piezoelectric layer is made of PZT, the electrodes are in AZO and the dielectric layer is made of TiO₂. The piezoelectric device has been submitted to a bias voltage. The results are represented in Figure 3 which shows a graphic of the electric displacement field P(µC/cm₂) according to the bias (V). The bias (V) represents the external electrical field applied to the piezoelectric material of the device. The graphic shows a hysteresis cycle. The hysteretic behaviour is characteristic of ferroelectric materials.

Figure 4 shows the evolution of the capacitance (pF) and the dielectric loss (tan (δ)) according to a bias voltage (V). The piezoelectric device has small losses, thanks to its in-plane configuration.

Figure 5 is a flowchart showing the major steps of the method for producing a transparent piezoelectric device according to the invention. The method comprises a step 100 of providing a transparent substrate, a step 102 of depositing a transparent piezoelectric layer on the transparent substrate and a step 104 of depositing a layer of transparent, interdigitated electrodes on the transparent substrate. The step 102 of depositing a transparent piezoelectric layer is performed before the step 104 of depositing the layer of interdigitated electrodes.

The method further comprises a step of depositing a transparent dielectric layer on the transparent substrate before the step of depositing a transparent piezoelectric layer. The dielectric layer can be used as a nucleation or buffer layer for the growth of the piezoelectric layer. The dielectric layer can be performed by evaporation of 20 nm of titanium followed by a thermal oxidation at 700°C during 30 min in air.

The step of depositing a transparent piezoelectric layer can be performed by spin coating and a sol gel method.

A spin coating was performed by first depositing a PZT precursor solution on the substrate. Then, the substrate was sequentially rotated during 20s at 20 rpm, then at 3600 rpm during 0.5s and at 1800 rpm during 30s.

After spin coating, a sol gel method was performed. A first step of drying was performed. The step of drying comprises a first annealing. A hot plate was used at 130°C during 5 min. A pyrolysis step was then performed. A second annealing was performed with an oven in air at 350° C during 5min in order to break the metal-organic precursor and burn the organic compounds.

The steps of spin coating, drying and pyrolysis are repeated 3 times. A crystallization step was then performed. Annealing was performed with an oven in air at 700°C during 5 min in order to crystallize the solid solution. The annealing can also be performed with a rapid thermal annealing process.

The step of depositing a transparent piezoelectric layer can also be performed by sputtering, MOCVD or pulsed laser deposition.

The step of depositing the layer of interdigitated electrodes can be performed by atomic layer deposition of a transparent conductive metal and a process of lift-off lithography or by a standard lithography process followed by etching. More particularly, the transparent conductive layer deposited by the method of atomic layer deposition comprises a transparent metal oxide, preferably Al-doped ZnO, Indium Tin Oxide (ITO), RuO₂ or IrO₂. Said materials can also be deposited by sputtering or evaporation instead of an atomic layer deposition method. In the case of ITO or AZO, a sol-gel process can be also performed.

The method can be used to produce a transparent piezoelectric device according to the invention with an active area higher than 1 cm². For example, the method can be used to produce the device with an active area of 100 cm².

## Claims

1. A transparent piezoelectric device (2) comprising:
- a transparent substrate (4);
- a transparent piezoelectric layer (6);
- a layer (8) of transparent, interdigitated electrodes;
the piezoelectric layer (6) being disposed between the substrate (4) and the layer (8) of interdigitated electrodes; wherein said device further comprises a transparent dielectric layer (10) between the substrate (4) and the piezoelectric layer (6), **characterized in that** the dielectric layer (10) has a thickness comprised between 1 and 30 nm.

2. The device (2) according to claim 1, wherein the transparent piezoelectric layer (6) is a uniform deposited layer.

3. The device (2) according to any of claims 1 to 2, wherein the layer (8) of interdigitated electrodes comprises two coplanar electrodes (8¹), each electrode having a plurality of fingers (8²) which are interdigitated.

4. The device (2) according to any of claims 1 to 3, wherein the piezoelectric layer (6) covers at least 10% of the surface of the transparent substrate (4), preferably at least 50%, more preferably at least 70%.

5. The device (2) according to any of claims 1 to 4, wherein the layer (8) of electrodes comprises a conductive transparent metal oxide.

6. The device (2) according to any of claims 1 to 5, wherein the substrate (4) is a fused silica wafer or a glass substrate.

7. The device (2) according to any one of claims 1 to 6, wherein the piezoelectric layer (6) has a thickness of less than 10 µm, preferably higher than 0.1 µm and/or lower than 2 µm.

8. The device (2) according to any one of claims 1 to 7, wherein the dielectric layer (10) has a thickness lower than 20 nm.

9. A method for producing a transparent piezoelectric device, said method comprising the following steps of:
- providing a transparent substrate (100);
- depositing a transparent piezoelectric layer on the transparent substrate (102);
- depositing a layer of transparent, interdigitated electrodes on the transparent substrate (104);
the step (102) of depositing a transparent piezoelectric layer is performed before the step (104) of depositing the layer of interdigitated electrodes; wherein said method further comprises a step of depositing a transparent dielectric layer on the transparent substrate before the step (102) of depositing a transparent piezoelectric layer on the transparent substrate,
**characterized in that** the dielectric layer has a thickness comprised between 1 and 30 nm.

10. The method according to claim 9, wherein the device is in accordance with any one of claims 1 to 8.

11. The method according to any one of claims 9 and 10, wherein the step (102) of depositing a transparent piezoelectric layer is performed by spin coating and a sol-gel method.

12. The method according to any one of claims 9 to 11, wherein the step (104) of depositing a layer of interdigitated electrodes is performed by atomic layer deposition and lift-off lithography, and/or lithography and etching.

13. The method according to claim 11, wherein the sol-gel method comprises the following sequential steps of:
- drying;
- pyrolizing; and
- crystallizing.

14. The method according to claims 11 and 13, wherein the spin coating and the steps of drying and pyrolizing are repeated 3 times.

## Patentansprüche

1. Transparente piezoelektrische Vorrichtung (2), die Folgendes umfasst:
- ein transparentes Substrat (4),
- eine transparente piezoelektrische Schicht (6),
- eine Schicht (8) aus transparenten, ineinandergreifenden Elektroden,
wobei die piezoelektrische Schicht (6) zwischen dem Substrat (4) und der Schicht (8) aus ineinandergreifenden Elektroden angeordnet ist,
wobei die Vorrichtung ferner eine transparente dielektrische Schicht (10) zwischen dem Substrat (4) und der piezoelektrischen Schicht (6) umfasst, **dadurch gekennzeichnet, dass** die dielektrische Schicht (10) eine Dicke zwischen 1 und 30 nm aufweist.

2. Die Vorrichtung (2) nach Anspruch 1, wobei die transparente piezoelektrische Schicht (6) eine gleichmäßig abgeschiedene Schicht ist.

3. Die Vorrichtung (2) nach einem der Ansprüche 1 bis 2, wobei die Schicht (8) der ineinandergreifenden Elektroden zwei koplanare Elektroden (8¹) umfasst, wobei jede Elektrode eine Vielzahl von Fingern (8²) aufweist, die ineinandergreifen.

4. Die Vorrichtung (2) nach einem der Ansprüche 1 bis 3, wobei die piezoelektrische Schicht (6) mindestens 10 % der Oberfläche des transparenten Substrats (4), vorzugsweise mindestens 50 %, noch besser mindestens 70 % abdeckt.

5. Die Vorrichtung (2) nach einem der Ansprüche 1 bis 4, wobei die Elektrodenschicht (8) ein leitfähiges transparentes Metalloxid beinhaltet.

6. Die Vorrichtung (2) nach einem der Ansprüche 1 bis 5, wobei das Substrat (4) ein Quarzglas-Wafer oder ein Glassubstrat ist.

7. Die Vorrichtung (2) nach einem der Ansprüche 1 bis 6, wobei die piezoelektrische Schicht (6) eine Dicke von weniger als 10 µm, vorzugsweise mehr als 0,1 µm und/oder weniger als 2 µm aufweist.

8. Die Vorrichtung (2) nach einem der Ansprüche 1 bis 7, wobei die dielektrische Schicht (10) eine Dicke von weniger als 20 nm aufweist.

9. Verfahren zur Herstellung einer transparenten piezoelektrischen Vorrichtung, wobei das Verfahren die folgenden Schritte umfasst:
- Bereitstellen eines transparenten Substrats (100);
- Abscheiden einer transparenten piezoelektrischen Schicht auf dem transparenten Substrat (102);
- Abscheiden einer Schicht von transparenten, ineinandergreifenden Elektroden auf dem transparenten Substrat (104);
der Schritt (102) des Abscheidens einer transparenten piezoelektrischen Schicht wird vor dem Schritt (104) des Abscheidens der Schicht aus ineinandergreifenden Elektroden durchgeführt,
wobei das Verfahren ferner einen Schritt des Abscheidens einer transparenten dielektrischen Schicht auf dem transparenten Substrat vor dem Schritt (102) des Abscheidens einer transparenten piezoelektrischen Schicht auf dem transparenten Substrat umfasst, **dadurch gekennzeichnet, dass** die dielektrische Schicht eine Dicke zwischen 1 und 30 nm aufweist.

10. Verfahren nach Anspruch 9, wobei die Vorrichtung einem der Ansprüche 1 bis 8 entspricht.

11. Verfahren nach einem der Ansprüche 9 und 10, wobei der Schritt (102) des Abscheidens einer transparenten piezoelektrischen Schicht durch Rotationsbeschichtung und einen Sol-Gel-Prozess durchgeführt wird.

12. Verfahren nach einem der Ansprüche 9 bis 11, wobei der Schritt (104) des Abscheidens einer Schicht von ineinandergreifenden Elektroden durch Atomschichtabscheidung und Lift-off-Lithographie und/oder Lithographie und Ätzen durchgeführt wird.

13. Verfahren nach Anspruch 11, wobei der Sol-Gel-Prozess die folgenden aufeinanderfolgenden Schritte umfasst:
- Trocknen,
- Pyrolyse und
- Kristallisierung.

14. Verfahren nach den Ansprüchen 11 und 13, wobei das Rotationsbeschichtung und die Schritte Trocknen und Pyrolyse dreimal wiederholt werden.

## Revendications

1. Dispositif piézoélectrique transparent (2) comprenant :
- un substrat transparent (4) ;
- une couche piézoélectrique transparente (6) ;
- une couche (8) d'électrodes entremêlées transparentes ;
la couche piézoélectrique (6) étant disposée entre le substrat (4) et la couche (8) d'électrodes emmêlées ;
dans lequel ledit dispositif comprend en outre une couche diélectrique transparente (10) entre le substrat (4) et la couche piézoélectrique (6) ;
**caractérisé en ce que** la couche diélectrique (10) possède une épaisseur comprise entre 1 et 30 nm.

2. Dispositif (2) selon la revendication 1, dans lequel la couche piézoélectrique transparente (6) représente une couche déposée de manière uniforme.

3. Dispositif (2) selon l'une quelconque des revendications 1 à 2, dans lequel la couche (8) d'électrodes entremêlées comprend deux électrodes coplanaires (8¹), chaque électrode possédant un certain nombre de doigts (8²) qui sont entremêlés.

4. Dispositif (2) selon l'une quelconque des revendications 1 à 3, dans lequel la couche piézoélectrique (6) recouvre au moins 10 % de la surface du substrat transparent (4), de préférence au moins 50 %, de manière plus préférée au moins 70%.

5. Dispositif (2) selon l'une quelconque des revendications 1 à 4, dans lequel la couche (8) d'électrodes comprend un oxyde métallique transparent conducteur.

6. Dispositif (2) selon l'une quelconque des revendications 1 à 5, dans lequel le substrat (4) représente une plaquette en verre de silice ou un substrat en verre.

7. Dispositif (2) selon l'une quelconque des revendications 1 à 6, dans lequel la couche piézoélectrique (6) possède une épaisseur inférieure à 10 µm, de préférence supérieure à 0,1 µm et/ou inférieure à 2 µm.

8. Dispositif (2) selon l'une quelconque des revendications 1 à 7, dans lequel la couche diélectrique (10) possède une épaisseur inférieure à 20 nm.

9. Procédé pour la production d'un dispositif piézoélectrique transparent, ledit procédé comprenant les étapes suivantes dans lesquelles :
- on procure un substrat transparent (100) ;
- on dépose une couche piézoélectrique transparente sur le substrat transparent (102) ;
- on dépose une couche d'électrodes entremêlées transparentes sur le substrat transparent (104) ;
l'étape (102) dans laquelle on dépose une couche piézoélectrique transparente est mise en œuvre avant l'étape (104) dans laquelle on dépose la couche d'électrodes entremêlées ;
dans lequel ledit procédé comprend en outre une étape dans laquelle on dépose une couche diélectrique transparente sur le substrat transparent avant l'étape (102) dans laquelle on dépose une couche piézoélectrique transparente sur le substrat transparent ;
**caractérisé en ce que** la couche diélectrique possède une épaisseur qui est comprise entre 1 et 30 nm.

10. Procédé selon la revendication 9, dans lequel le dispositif est conforme à l'une quelconque des revendications 1 à 8.

11. Procédé selon l'une quelconque des revendications 9 et 10, dans lequel l'étape (102) dans laquelle on dépose une couche piézoélectrique transparente est mise en œuvre par l'intermédiaire d'une technique de dépôt par rotation et d'un procédé sol-gel.

12. Procédé selon l'une quelconque des revendications 9 à 11, dans lequel l'étape (102) dans laquelle on dépose une couche d'électrodes entremêlées est mise en œuvre par l'intermédiaire d'un dépôt de couches atomiques et d'une lithographie par décollement et/ou par l'intermédiaire d'une lithographie et d'une gravure.

13. Procédé selon la revendication 11, dans lequel le procédé sol-gel comprend les étapes successives suivantes dans lesquelles on procède à :
- un séchage ;
- une pyrolyse ; et
- une cristallisation.

14. Procédé selon les revendications 11 et 13, dans lequel la technique de dépôt par rotation et les étapes de séchage et de pyrolyses sont répétées à trois reprises.
